# EUROPÄISCHE PATENTSCHRIFT

(11) **EP 1 926 784 B1**
(45) Veröffentlichungstag und Bekanntmachung des Hinweises auf die Patenterteilung: **13.01.2010**
(21) Anmeldenummer: 06793112.1
(22) Anmeldetag: 31.08.2006
(51) Int. Cl.: C09D 5/24

(54) **DISPERSION ENTHALTEND ZWEI VERSCHIEDENE METALLE ZUM AUFBRINGEN EINER METALLSCHICHT**
DISPERSION FOR APPLYING A METAL LAYER
DISPERSION A APPLIQUER SUR UNE COUCHE METALLIQUE

(30) Priorität: 09.09.2005 DE 102005043242
(43) Veröffentlichungstag der Anmeldung: 04.06.2008
(60) Teilanmeldung: 09173628.0
(73) Patentinhaber: BASF SE, 67056 Ludwigshafen (DE)
(72) Erfinder: SCHNEIDER, Norbert, 67122 Altrip (DE); LIPPERT, Gerald, 68623 Lampertheim (DE); LOCHTMAN, Rene, 68161 Mannheim (DE); MAAS, Heiko, 68165 Mannheim (DE); PFISTER, Jürgen, 67346 Speyer (DE); SOBOTKA, Bettina, 68167 Mannheim (DE); WAGNER, Norbert, 67112 Mutterstadt (DE)
(86) Internationale Anmeldenummer: PCT/EP2006/065875
(87) Internationale Veröffentlichungsnummer: WO 2007/028762

(56) Entgegenhaltungen:
- EP-A- 0 546 560
- EP-A- 1 086 967
- WO-A-00/47660
- WO-A-92/09992
- DE-A1- 10 029 699
- US-A- 5 320 781
- DATABASE WPI Week 198520 Derwent Publications Ltd., London, GB; AN 1985-119706 XP002427101 -& JP 60 060168 A (TOPPAN PRINTING CO LTD) 6. April 1985 (1985-04-06)

## Beschreibung

Die vorliegende Erfindung betrifft ein Verfahren zur Herstellung einer Metallschicht auf einem Substrat mit Hilfe einer Dispersion. Die Erfindung betrifft weiterhin derart beschichtete Substratoberflächen sowie deren Verwendung.

Zur Herstellung von elektrisch leitenden metallischen Schichten auf Substraten, die den elektrischen Strom nicht leiten, sind verschiedene Techniken bekannt. So können elektrisch nicht leitende Substrate, wie beispielsweise Kunststoffe, mit Metallen im Hochvakuum bedampft werden, wobei solche Verfahren aufwendig und kostspielig sind.

Üblicherweise werden Kunststoffe metallisiert, indem eine Reihe von Prozessschritten hintereinander durchgeführt wird. Hierbei erfolgt zunächst ein Oberflächenaktivierungsschritt durch starke Säuren oder Basen. Dabei kommen häufig gesundheitlich bedenkliche Substanzen wie beispielsweise Chromschwefelsäure zum Einsatz. Anschließend findet eine Beschichtung der Kunststoffoberfläche durch Lösungen mit geeigneten Übergangsmetallkomplexen statt. Diese erlauben dabei eine Metallisierung der aktivierten Kunststoffoberfläche.

Leitfähige Beschichtungen auf nicht elektrisch leitfähigen Oberflächen können aber auch durch Leitlacke oder Leitpasten erhalten werden, die auf den Kunststoff aufgetragen werden und dabei jedoch eine gute Haftung auf dem Material aufweisen müssen.

DE-A 1 615 786 beschreibt beispielsweise Verfahren zur Herstellung von elektrisch leitenden Schichten auf elektrisch nicht leitenden Oberflächen mit Hilfe einer Lackschicht, die fein verteiltes Eisen enthält. Der Lack soll außerdem ein organisches Lösemittel sowie bestimmte Anteile an Bindemittel enthalten.

Es ist jedoch bekannt, dass solche Leitlacke nur relativ geringe Leitwerte aufweisen, da die dispergierten metallischen Teilchen durch das Bindemittel keine zusammenhängende Leitschicht bilden. So erreichen die Leitwerte dieser Schichten nicht diejenigen von Metallfolien vergleichbarer Dicke. Eine Erhöhung des Anteils an Metallpigment innerhalb der Schicht würde zwar auch eine Erhöhung der Leitwerte zur Folge haben, jedoch treten hierbei häufig Probleme auf, die auf eine zu geringe Haftfestigkeit der leitenden Schicht auf der Kunststoffoberfläche zurückzuführen sind.

DE-A 1 521 152 schlägt daher vor, einen Leitlack auf die elektrisch nicht leitende Oberfläche aufzubringen, der ein Bindemittel sowie fein verteiltes Eisen enthält und anschließend auf den Leitlack eine Schicht von Silber oder von Kupfer stromlos aufzubringen. Danach kann eine weitere Schicht stromlos oder galvanisch aufgebracht werden.

EP-B 200 772 beschreibt die Beschichtung eines elektrisch nicht leitenden Gegenstands mit Hilfe eines fluiden organischen Farbbindemittels, um eine elektromagnetische Abschirmung bei einer Frequenz von mehr als 10 kHz zu erreichen. Hierbei wird zunächst eine Primärschicht mit dem fluiden organischen Farbbindemittel, in welchem aktive Metallteilchen dispergiert sind, aufgebracht und anschließend eine zweite Schicht von Kupfer stromlos auf der primären Schicht abgelagert und schließlich eine dritte Schicht aus einem e-lektroplatinierten Metall auf die zweite Schicht aufgebracht.

DE-A 199 45 400 beschreibt unter anderem eine Magnetdispersion, welche ein spezielles Bindemittel enthalten soll, sowie ein magnetisches oder magnetisierbares Material.

Es besteht ein Bedarf, optimierte Systeme zur metallischen Beschichtung von elektrisch nicht leitenden Substraten zu ermöglichen, die insbesondere eine verbesserte Haftfestigkeit aufweisen, die umweltfreundlich, kostengünstig und zuverlässig sind und mit einer hohen Arbeitsgeschwindigkeit angewendet werden können. Die im Stand der Technik bekannten Systeme erlauben bislang keine großtechnische Nutzung.

Eine Aufgabe der vorliegenden Erfindung liegt somit darin, ein Verfahren bereitzustellen, die das Aufbringen einer Metallschicht auf einem elektrisch nicht leitenden Substrat ermöglicht, wobei insbesondere eine erhöhte Haftfestigkeit und/oder Schichthomogenität der Metallschicht erzielt werden kann.

Diese Aufgabe wird gelöst durch ein Verfahren zur Herstellung einer Metallschicht auf zumindest einem Teil der Oberfläche eines nicht leitfähigen Substrats die Schritte enthaltend
a) Aufbringen einer Dispersion zum Aufbringen einer Metallschicht auf einem elektrisch nicht leitfähigen Substrat enthaltend
   A 0,01 bis 30 Ges.-% bezogen auf das Gesamtgewicht der Dispersion einer organischen Bindemittelkomponente;
   B 30 bis 89,99 Gew.-% bezogen auf das Gesamtgewicht der Dispersion einer Metallkomponente mindestens enthaltend
      B1 0,01 bis 99,99 Gew.-% bezogen auf das Gesamtgewicht der Metallkomponente B eines ersten Metalls mit einer ersten Metallteilchenform und
      B2 99,99 bis 0,01 Gew.-% bezogen auf das Gesamtgewicht der Metallkomponente B eines zweiten Metalls mit einer zweiten Metallteilchenform;
   C 10 bis 69,99 Gew.-% bezogen auf das Gesamtgewicht der Dispersion einer Lösemittelkomponente;
      wobei mindestens eine der folgenden Bedingungen erfüllt ist:
      (1) Das erste und zweite Metall sind verschieden;
      (2) Die erste und zweite Teilchenform sind verschieden
   auf dem Substrat;
b) Trocknen und/oder Aushärten der aufgebrachten Schicht auf dem Substrat; und
c) gegebenenfalls stromlose und/oder galvanische Abscheidung eines Metalls auf der getrockneten und/oder ausgehärteten Dispersionsschicht.

Es wurde nämlich gefunden, dass das Vorliegen unterschiedlicher Metalle und/oder Teilchenformen in der Dispersion zu einer metallischen Primärschicht nach Auftragen führen kann, die gemeinsam mit einer weiteren metallischen Schicht, welche stromlos und/oder galvanisch aufgebracht wird, zu einer Metallschicht führt, die verbesserte Eigenschaften aufweist.

Die Dispersion kann weiterhin mindestens eine der Komponenten
D) mit 0,01 bis 50 Gew.-% bezogen auf das Gesamtgewicht der Dispersion einer Dispergiermittelkomponente; sowie
E) mit 0,01 bis 50 Gew.-% bezogen auf das Gesamtgewicht der Dispersion einer Füllstoffkomponente enthalten.

### Komponente A

Bei der organischen Bindemittelkomponente A handelt es sich um ein Bindemittel oder Bindemittelgemisch. Mögliche Bindemittel sind Bindemittel mit pigmentaffiner Ankergruppe, natürliche und synthetische Polymere und deren Derivate, Naturharze sowie synthetische Harze und deren Derivate, Naturkautschuk, synthetischer Kautschuk, Proteine, Cellulosederivate, trocknende und nicht trocknende Öle und dergleichen. Diese können - müssen jedoch nicht - chemisch oder physikalisch härtend, beispielsweise luftaushärtend, strahlungshärtend oder temperaturhärtend, sein.

Vorzugsweise handelt es sich bei der Bindemittelkomponente A um ein Polymer oder Polymergemisch.

Bevorzugte Polymere als Komponente A sind ABS (Acrylnitril-Butadien-Styrol); ASA (Acrylnitril-Styrol-Acrylat); acrylierte Acrylate; Alkydharze; Alkylvinylacetate; Alkylenvinylacetat-Copolymere, insbesondere Methylenvinylacetat, Ethylenvinylacetat, Butylenvinylacetat; Alkylenvinylchlorid-Copolymere; Aminoharze; Aldehyd- und Ketonharze; Cellulose und Cellulosederivate, insbesondere Alkylcellulose, Celluloseester, wie -Acetate, -Propionate, - Butyrate, Celluloseether, Carboxyalkylcellulosen, Cellulosenitrat; Epoxyacrylate; Epoxidharze; Ethylenacrylsäurecopolymere; Kohlenwasserstoffharze; MABS (transparentes ABS mit Acrylat-Einheiten enthaltend); Maleinsäureanhydridcopolymerisate; Methacrylate, gegebenenfalls aminfunktionalisiert; Naturkautschuk; synthetischer Kautschuk; Chlorkautschuk; Naturharze; Kollophoniumharze; Schellack; Phenolharze; Polyester; Polyesterharze wie Phenylesterharze; Polysulfone; Polyethersulfone; Polyamide; Polyimide; Polyaniline; Polypyrrole; Polybutylenterephthalat (PBT); Polycarbonat (zum Beispiel Makrolon^{®} der Bayer AG); Polyesteracrylate; Polyetheracrylate; Polyethylen; Polyethylenthiophene; Polyethylennaphthalate; Polyethylenterephthalat (PET); Polyethylenterephthalat-Glykol (PETG); Polypropylen; Polymethylmethacrylat (PMMA); Polyphenylenoxid (PPO); Polytertrafluorethylen (PTFE); Polytetrahydrofuran; Polyvinylverbindungen, insbesondere Polyvinylchlorid (PVC), PVC-Copolymere, PVdC, Polyvinylacetat sowie deren Copolymere, gegebenenfalls teilhydrolysierter Polyvinylalkohol, Polyvinylacetate, Polyvinylpyrrolidon, Polyvinylether, Polyvinylacrylate und -methacrylate in Lösung und als Dispersion sowie deren Copolymere, Polyacrylsäureester und Polystyrolcopolymere; Polystyrol (schlagfest oder nicht schlagfest modifiziert; Polyurethane, unvernetzte beziehungsweise mit Isocyanaten versetzt; Polyurethanacrylate; Styro-Acryl-Copolymere; Styrol-Butadien-Blockcopolymere (zum Beispiel Styroflex^{®} oder Styrolux^{®} der BASF AG, K-Resin^{™} der CPC); Proteine wie zum Beispiel Casein; SIS; SPS-Blockcopolymere. Weiterhin können Mischungen zweier oder mehrerer Polymere die organische Bindemittelkomponente A) bilden.

Bevorzugte Polymere als Komponente A sind Polyalkylene, Polyimide, Epoxy- und Phenolharze, Styrol-Butadien-Blockcopolymere, Alkylenvinylacetate und -chlorid-Copolymere, Polyamide sowie deren Copolymere.

Bezogen auf das Gesamtgewicht der Dispersion beträgt der Anteil der organischen Bindemittelkomponente A) 0,01 bis 30 Gew.-%. Vorzugsweise liegt der Anteil bei 0,1 bis 10 Gew.-%, mehr bevorzugt bei 0,5 bis 5 Gew.-%.

### Komponente B

Die Metallkomponente B enthält mindestens ein erstes Metall mit einer ersten Metallteilchenform und ein zweites Metall mit einer zweiten Metallteilchenform.

Bei dem ersten Metall kann es sich um ein Metall handeln, das gleich oder verschieden vom zweiten Metall ist. Ebenso kann die erste Metallteilchenform gleich oder verschieden von der zweiten Metallteilchenform sein. Wesentlich ist jedoch, dass sich wenigstens die Metalle oder die Teilchenformen unterscheiden. Möglich ist jedoch auch, dass sowohl das erste und das zweite Metall als auch die erste und zweite Teilchenform verschieden voneinander sind.

Die Dispersion kann neben den Metallkomponenten B1 und B2 weitere Metalle, die verschieden zum ersten und zweiten Metall, verschieden zum ersten oder zweiten Metall, oder gleich dem ersten und zweiten Metall sind, aufweisen. Analoges gilt für die Metallteilchenform eines weiteren Metalls. Im Rahmen der vorliegenden Erfindung muss nur gewährleistet sein, dass zumindest ein erstes und zweites Metall sowie eine erste Metallteilchenform und eine zweite Metallteilchenform unter der Bedingung vorhanden sind, dass das erste und zweite Metall verschieden sind und/oder dass die erste und zweite Teilchenform verschieden voneinander sind.

Im Rahmen der vorliegenden Erfindung weisen die Metalle die Oxidationsstufe 0 auf und können als Metallpulver der Dispersion zugeführt werden.

Vorzugsweise besitzen die Metalle einen mittleren Teilchendurchmesser von 0,01 bis 100 µm, bevorzugt von 0,05 bis 50 µm und insbesondere bevorzugt von 0,1 bis 10 µm. Der mittlere Teilchendurchmesser kann mittels Laserbeugungsmessung beispielsweise an einem Gerät Microtrac X100 ermittelt werden. Die Verteilung der Teilchendurchmesser hängt von deren Herstellverfahren ab. Typischerweise weist die Durchmesserverteilung nur ein Maximum auf, mehrere Maxima sind jedoch auch möglich.

Geeignete Metalle sind beispielsweise Zink, Nickel, Kupfer, Zinn, Kobalt, Mangan, Eisen, Magnesium, Blei, Chrom, Wismut Silber, Gold, Aluminium, Titan, Palladium, Platin, Tantal sowie Legierungen hiervon. Geeignete Legierungen sind beispielsweise CuZn, CuSn, Cu-Ni, SnPb, SnBi, SnCo, NiPb, ZnFe, ZnNi, ZnCo und ZnMn. Insbesondere bevorzugt sind Eisen, Zink, Aluminium und Kupfer.

Das Metall kann neben dem metallischen Anteil auch einen nicht-metallischen Anteil aufweisen. So kann die Oberfläche des Metalls zumindest teilweise mit einer Beschichtung ("Coating") versehen sein. Geeignete Coatings können anorganischer (zum Beispiel SiO₂, Phosphate) oder organischer Natur sein. Selbstverständlich kann das Metall auch mit einem weiteren Metall oder Metalloxid gecoatet sein. Ebenfalls kann das Metall in teilweise oxidierter Form vorliegen.

Sollen zwei unterschiedliche Metalle die Metallkomponente B bilden, so kann dies durch eine Mischung zweier Metalle erfolgen. Insbesondere bevorzugt ist es, wenn die beiden Metalle ausgewählt sind aus der Gruppe bestehend aus Eisen, Zink, Aluminium und Kupfer.

Die Metallkomponente B kann jedoch auch ein erstes Metall und ein zweites Metall enthalten, bei dem das zweite Metall in Form einer Legierung (mit dem ersten Metall oder einem oder mehreren anderen Metallen) vorliegt, oder die Metallkomponente B enthält zwei unterschiedlichen Legierungen. Auch für diese beiden Fälle sind jeweils die Metallkomponenten B1 und B2 voneinander verschieden, so dass deren Metallteilchenform unabhängig voneinander gleich oder verschieden gewählt werden kann.

Neben der Auswahl der Metalle hat die Metallteilchenform der Metalle einen Einfluss auf die Eigenschaften der Dispersion nach einer Beschichtung. Im Hinblick auf die Form sind zahlreiche dem Fachmann bekannte Varianten möglich. Die Form des Metallteilchens kann beispielsweise nadelförmig, zylindrisch, plattenförmig oder kugelförmig sein. Diese Teilchenformen stellen idealisierte Formen dar, wobei die tatsächliche Form, beispielsweise herstellungsbedingt, mehr oder weniger stark hiervon abweichen kann. So sind beispielsweise tropfenförmige Teilchen im Rahmen der vorliegenden Erfindung eine reale Abweichung der idealisierten Kugelform.

Metalle mit verschiedenen Teilchenformen sind kommerziell erhältlich.

Sofern sich die Metallkomponente B1 und B2 in ihrer Metallteilchenform unterscheidet, ist bevorzugt, wenn die erste kugelförmig und die zweite plattenförmig oder nadelförmig ist.

Im Falle unterschiedlicher Teilchenformen sind ebenfalls die Metalle Eisen, Kupfer, Zink und Aluminium bevorzugt.

Wie bereits oben ausgeführt, können die Metalle in Form ihrer Pulver der Dispersion zugefügt werden. Derartige Metallpulver sind gängige Handelswaren oder können mittels bekannter Verfahren leicht hergestellt werden, etwa durch elektrolytische Abscheidung oder chemische Reduktion aus Lösungen der Metallsalze oder durch Reduktion eines oxidischen Pulvers beispielsweise mittels Wasserstoff, durch Versprühen oder Verdüsen einer Metallschmelze, insbesondere in Kühlmedien, beispielsweise Gasen oder Wasser. Bevorzugt ist das Gas- und Wasserverdüsen.

Im Falle des Eisens ist neben dem Gas- und Wasserverdüsen der Carbonyleisen-Pulver Prozess (CEP-Prozess) zur Herstellung von Carbonyleisen Pulver bevorzugt. Dieser erfolgt durch thermische Zersetzung von Eisenpentacarbonyl. Dies wird beispielsweise in Ullman's Encyclopedia of Industrial Chemistry, 5th Edition, Vol. A14, Seite 599 beschrieben. Die Zersetzung des Eisenpentacarbonyls kann beispielsweise bei erhöhten Temperaturen und erhöhten Drücken in einem beheizbaren Zersetzer erfolgen, der ein Rohr aus einem hitzebeständigen Material wie Quarzglas oder V2A-Stahl in vorzugsweise vertikaler Position umfasst, das von einer Heizeinrichtung, beispielsweise bestehend aus Heizbädern, Heizdrähten oder aus einem von einem Heizmedium durchströmten Heizmantel umgeben ist.

Plättchenförmige Metalle können durch optimierte Bedingungen im Herstellprozess kontrolliert werden oder im Nachhinein durch mechanische Behandlung beispielsweise durch Behandlung in einer Rührwerkskugelmühle erhalten werden.

Bezogen auf das Gesamtgewicht der Dispersion liegt die Metallkomponente B bei einem Anteil von 30 bis 89,99 Gew.-%. Die Metallteilkomponente B1 weist einen Anteil von 99,99 bis 0,01 Gew.-% bezogen auf das Gesamtgewicht der Komponente B auf. Die Metallteilkomponente B2 weist einen Anteil von 0,01 bis 99,99 Gew.-% auf. Sind keine weiteren Metalle vorhanden, ergeben B1 und B2 zu 100 % die Metallkomponente B.

Ein bevorzugter Bereich von B liegt bei 50 bis 85 Gew.-% bezogen auf das Gesamtgewicht der Dispersion.

Das gewichtsmäßige Verhältnis der Komponenten B1 und B2 liegt vorzugsweise im Bereich von 1000:1 bis 1:1, mehr bevorzugt bei 100:1 bis 1:1 am meisten bevorzugt im Bereich 20:1 bis 1:1.

### Komponente C

Weiterhin enthält die Dispersion eine Lösemittelkomponente C. Diese besteht aus einem Lösemittel oder einem Lösemittelgemisch.

Geeignete Lösemittel sind Aceton, Alkylacetate, Alkoxypropanole (zum Beispiel Methoxypropanol), Amylalkohol, Butanol, Butylacetat, Butyldiglykol, Alkylglykolacetate, wie Butylglykolacetat, Butylglykol, Chloroform, Cyclohexan, Cyclohexanon, Diacetonalkohol, Diethylether, Diglykoldimethylether, Dioxan, Ethanol, Ethylacetat, Ethylbenzol, Ethylenchlorid, Ethylenglykol, Ethylenglykolacetat, Ethylenglykoldimethylester, Isobutanol, Isobutylacetat, Isopropylacetat, Kresol, Methanol, Methoxybutanol, Methylacetat, 3-Methylbutanol, Methyldiglykol, Methylenchlorid, Methylenglykol, Methylethylketon (MEK), Methylisobutylketon (MIBK), Methylglykolacetat, Methylphenol (ortho-, meta-, para-Kresol), 1-Propanol, 2-Propanol, Propylacetat, Propylenglykol, Tetrachlorkohlenstoff, Tetrahydrofuran, Toluol, Trimethylolpropan (TMP), alkoholische Monoterpine (wie zum Beispiel Terpineol), Wasser sowie Mischungen aus zwei oder mehreren dieser Lösemittel.

Bevorzugte Lösemittel sind Alkoxypropanol, Cyclohexan, Ethanol, Ethylacetat, Butylacetat, 1-Prpanol, 2-Propanol, Tetrahydrofuran, Ethylbenzol, Butylglykolacetat, Wasser sowie Mischungen davon.

Die Lösemittelkomponente C weist einen Anteil bezogen auf das Gesamtgewicht der Dispersion von 10 bis 69,99 Gew.-% auf. Vorzugsweise beträgt der Anteil 15 bis 50 Gew.-%.

### Komponente D

Die Dispersion kann weiterhin eine Dispergiermittelkomponente D enthalten. Diese besteht aus einem oder mehreren Dispergiermitteln.

Grundsätzlich sind alle dem Fachmann für die Anwendung in Dispersionen bekannten und im Stand der Technik beschriebenen Dispergiermittel geeignet. Bevorzugte Dispergiermittel sind Tenside oder Tensidgemische, beispielsweise anionische, kationische, amphotere oder nichtionische Tenside.

Kationische und anionische Tenside sind beispielsweise in "Encyclopedia of Polymer Science and Technology", J. Wiley & Sons (1966), Band 5, Seiten 816 bis 818, und in "Emulsion Polymerisation and Emulsion Polymers", Herausgeber P. Lovell und M. EI-Asser, Verlag Wiley & Sons (1997), Seiten 224-226, beschrieben.

Beispiele für anionische Tenside sind Alkalisalze von organischen Carbonsäuren mit Kettenlängen von 8 bis 30 C-Atomen, vorzugsweise 12 bis 18 C-Atomen. Diese werden im Allgemeinen als Seifen bezeichnet. In der Regel werden Sie als Natrium-, Kalium- oder Ammoniumsalze eingesetzt. Zudem können Alkylsulfate und Alkyl- oder Alkylarylsulfonate mit 8 bis 30 C-Atomen, bevorzugt 12 bis 18 C-Atomen als anionische Tenside eingesetzt werden. Besonders geeignete Verbindungen sind Alkalidodecylsulfate, z.B. Natriumdodecylsulfat oder Kaliumdodecylsulfat, und Alkalisalze von C₁₂-C₁₆-Paraffinsulfonsäuren. Weiterhin sind Natriumdodecylbenzolsulfonat und Natriumdioctylsulfonsuccinat geeignet.

Beispiele geeigneter kationische Tenside sind Salze von Aminen oder Diaminen, quartäre Ammoniumsalze, wie z.B. Hexadecyltrimethylammoniumbromid sowie Salze von langkettigen substituierten cyclischen Aminen, wie Pyridin, Morpholin, Piperidin. Insbesondere werden quartäre Ammoniumsalze, wie z.B. Hexadecyltrimethylammoniumbromid von Trialkylaminen eingesetzt. Die Alkylreste weisen darin vorzugsweise 1 bis 20 C-Atome auf.

Insbesondere können erfindungsgemäß nichtionische Tenside in der Komponente D eingesetzt werden. Nichtionische Tenside werden beispielsweise in CD Römpp Chemie Lexikon - Version 1.0, Stuttgart/New York: Georg Thieme Verlag 1995, Stichwort "Nichtionische Tenside" beschrieben.

Geeignete nichtionische Tenside sind beispielsweise polyethylenoxid- oder polypropylenoxidbasierte Stoffe wie Pluronic® oder Tetronic® der BASF Aktiengesellschaft.

Als nichtionische Tenside geeignete Polyalkylenglykole haben im Allgemeinen ein zahlengemitteltes Molekulargewicht Mₙ im Bereich von 1000 bis 15000 g/mol, bevorzugt 2000 bis 13000 g/mol, besonders bevorzugt 4000 bis 11000 g/mol. Bevorzugte nichtionische Tenside sind Polyethylenglykole.

Die Polyalkylenglykole sind an sich bekannt oder können nach an sich bekannten Verfahren, beispielsweise durch anionische Polymerisation mit Alkalihydroxiden, wie Natrium-oder Kaliumhydroxid oder Alkalialkoholaten, wie Natriummethylat, Natrium- oder Kaliumethylat oder Kaliumisopropylat, als Katalysatoren und unter Zusatz mindestens eines Startermoleküls, das 2 bis 8, vorzugsweise 2 bis 6, reaktive Wasserstoffatome gebunden enthält, oder durch kationische Polymerisation mit Lewis-Säuren, wie Antimonpentachlorid, Borfluorid-Etherat oder Bleicherde, als Katalysatoren aus einem oder mehreren Alkylenoxiden mit 2 bis 4 Kohlenstoffatomen im Alkylenrest hergestellt werden.

Geeignete Alkylenoxide sind beispielsweise Tetrahydrofuran, 1,2- bzw. 2,3-Butylenoxid, Styroloxid und vorzugsweise Ethylenoxid und/oder 1,2-Propylenoxid. Die Alkylenoxide können einzeln, alternierend nacheinander oder als Mischungen eingesetzt werden: Als Startermoleküle kommen beispielsweise in Betracht: Wasser, organische Dicarbonsäuren, wie Bernsteinsäure, Adipinsäure, Phthalsäure oder Terephthalsäure, aliphatische oder αromatische, gegebenenfalls N-mono-, N,N- oder N,N'-dialkylsubstituierte Diamine mit 1 bis 4 Kohlenstoffatomen im Alkylrest, wie gegebenenfalls mono- und dialkylsubstituiertes Ethylendiamin, Diethylentriamin, Triethylentetramin, 1,3-Propylendiamin, 1,3- bzw. 1,4-Butylendiamin, 1,2-, 1,3-, 1,4-, 1,5- oder 1,6-Hexamethylendiamin.

Als Startermoleküle kommen ferner in Betracht: Alkanolamine, z.B. Ethanolamin, N-Methyl- und N-Ethylethanolamin, Dialkanolamine, z.B. Diethanolamin, N-Methyl- und N-Ethyldiethanolamin, und Trialkanolamine, z.B. Triethanolamin, und Ammoniak. Vorzugsweise verwendet werden mehrwertige, insbesondere zwei-, dreiwertige oder höherwertige Alkohole, wie Ethandiol, Propandiol-1,2 und -1,3, Diethylenglykol, Dipropylenglykol, Butandiol-1,4, Hexandiol-1,6, Glycerin, Trimethylolpropan, .Pentaerythrit, und Saccharose, Sorbit und Sorbitol.

Für die Komponente D ebenfalls geeignet sind veresterte Polyalkylenglykole, beispielsweise die Mono-, Di-, Tri- oder Polyester der genannten Polyalkylenglykole, die durch Reaktion der endständigen OH-Gruppen der genannten Polyalkylenglykole mit organischen Säuren, bevorzugt Adipinsäure oder Terephthalsäure, in an sich bekannter Weise herstellbar sind.

Nichtionische Tenside sind durch Alkoxylierung von Verbindungen mit aktiven Wasserstoffatomen hergestellte Stoffe, beispielsweise Anlagerungsprodukte von Alkylenoxid an Fettalkohole, Oxoalkohole oder Alkylphenole. Es können somit beispielsweise zur Alkoxylierung Ethylenoxid oder 1,2-Propylenoxid eingesetzt werden.

Weitere mögliche nichtionische Tenside sind alkoxylierte oder nicht-alkoxylierte Zuckerester oder Zuckerether.

Zuckerether sind durch Umsetzung von Fettalkoholen mit Zuckern gewonnene Alkylglykoside. Zuckerester werden durch Umsetzung von Zuckern mit Fettsäuren erhalten. Die zur Herstellung der genannten Stoffe nötigen Zucker, Fettalkohole und Fettsäuren sind dem Fachmann bekannt.

Geeignete Zucker werden beispielsweise in Beyer/Walter, Lehrbuch der organischen Chemie, S. Hirzel Verlag Stuttgart, 19. Auflage, 1981, S. 392 bis 425 beschrieben. Mögliche Zucker sind D-Sorbit und die durch Dehydratisierung von D-Sorbit gewonnenen Sorbitane.

Geeignete Fettsäuren sind gesättigte oder ein- oder mehrfach ungesättigte unverzweigte oder verzweigte Carbonsäuren mit 6 bis 26, bevorzugt 8 bis 22, besonders bevorzugt 10 bis 20 C-Atomen, wie beispielsweise in CD Römpp Chemie Lexikon, Version 1.0, Stuttgart/New York: Georg Thieme Verlag 1995, Stichwort "Fettsäuren" genannt werden. Denkbar sind Fettsäuren wie Laurinsäure, Palmitinsäure, Stearinsäure und Ölsäure.

Geeignete Fettalkohole besitzen das gleiche Kohlenstoffgerüst wie die als geeignete Fettsäuren beschriebenen Verbindungen.

Zuckerether, Zuckerester und die Verfahren zu deren Herstellung sind dem Fachmann bekannt. Bevorzugte Zuckerether werden nach bekannten Verfahren durch Umsetzung der genannten Zucker mit den genannten Fettalkoholen hergestellt. Bevorzugte Zuckerester werden nach bekannten Verfahren durch Umsetzung der genannten Zucker mit den genannten Fettsäuren hergestellt. Geeignete Zuckerester sind Mono-, Di- und Triester der Sorbitane mit Fettsäuren, insbesondere Sorbitanmonolaurat, Sorbitandilaurat, Sorbitantrilaurat, Sorbitanmonooleat, Sorbitandioleat, Sorbitantrioleat, Sorbitanmonopalmitat, Sorbitandipalmitat, Sorbitantripalmitat, Sorbitanmonostearat, Sorbitandistearat, Sorbitantristearat und Sorbitansesquioleat, einer Mischung von Sorbitanmono- und Diestern der Ölsäure.

Möglich für die Komponente D sind somit alkoxylierte Zuckerether und Zuckerester, die durch Alkoxylierung der genannten Zuckerether und Zuckerester erhalten werden. Bevorzugte Alkoxylierungsmittel sind Ethylenoxid und 1,2-Propylenoxid. Der Alkoxylierungsgrad liegt in der Regel zwischen 1 und 20, bevorzugt 2 und 10, besonders bevorzugt 2 und 6. Beispiele hierfür sind Polysorbate, die durch Ethoxylierung der oben beschriebenen Sorbitanester erhalten werden, beispielsweise beschrieben in CD Römpp Chemie Lexikon - Version 1.0, Stuttgart/New York: Georg Thieme Verlag 1995, Stichwort "Polysorbate". Geeignete Polysorbate sind Polyethoxysorbitanlaurat, -stearat, -palmitat, -tristearat, - oleat, -trioleat, insbesondere Polyethoxysorbitanstearat, welches z.B. als Tween^{®}60 der ICI America Inc. erhältlich ist (beispielsweise beschrieben in CD Römpp Chemie Lexikon - Version 1.0, Stuttgart/New York: Georg Thieme Verlag 1995. Stichwort "Tween^{®}").

Die Verwendung von Polymeren als Dispergiermittel ist ebenfalls möglich.

Die Dispergiermittelkomponente D kann bezogen auf das Gesamtgewicht der Dispersion im Bereich von 0,01 bis 50 Gew.-% eingesetzt werden. Vorzugsweise beträgt der Anteil 0,1 bis 10 Gew.-%, besonders bevorzugt 0,3 bis 5 Gew.%.

### Komponente E

Weiterhin kann die Dispersion eine Füllstoffkomponente E enthalten. Diese kann aus einem oder mehreren Füllstoffen bestehen. So kann die Komponente E der metallisierbaren Masse faser- oder teilchenförmiger Füllstoffe oder deren Mischungen enthalten. Dabei handelt es sich vorzugsweise um kommerziell erhältliche Produkte, wie beispielsweise Kohlenstofffasern und Glasfasern.

Verwendbare Glasfasern können aus E-, A- oder C-Glas sein und sind vorzugsweise mit einer Schlichte und einem Haftvermittler ausgerüstet. Ihr Durchmesser liegt im Allgemeinen zwischen 1 und 20 µm. Es können sowohl Endlosfasern (rovings) als auch Schnittglasfasem (staple) mit einer Länge von 1 bis 10 mm, vorzugsweise 3 bis 6 mm, eingesetzt werden.

Weiterhin können Füll- oder Verstärkungsstoffe, wie Glaspulver, Glasgewebe, Glasvlies, Mineralfasern, Whisker, Aluminiumoxidfasern, Glimmer, Quarzmehl oder Wollastonit eingesetzt werden. Weiterhin sind Kohlenstoff, Kieselsäure. Silikate, wie zum Beispiel Aerosile oder Schichtsilikate, Farbstoffe, Fettsäuren, -amide, Weichmacher, Netzmittel, Trockenstoffe, Komplexbildner, Calciumcarbonat, Bariumsulfat, Wachse, Pigmente, leitfähige Polymerpartikel oder Aramidfasern einsetzbar.

Der Anteil der Komponente E bezogen auf das Gesamtgewicht der Dispersion beträgt vorzugsweise 0,01 bis 50 Gew.-%. Weiterhin bevorzugt sind 0,1 bis 10 Gew.%, besonders bevorzugt sind 0,3 bis 5 Gew.-%.

Weiterhin können Verarbeitungshilfsmittel und Stabilisatoren wie UV-Stabilisatoren, Schmiermittel, Korrosionsinhibitoren und Flammschutzmittel in der erfindungsgemäßen Dispersion vorliegen. Üblicherweise beträgt deren Anteil bezogen auf das Gesamtgewicht der Dispersion 0,01 bis 5 Gew.-%. Vorzugsweise liegt der Anteil bei 0,05 bis 3 Gew.-%.

Ein Verfahren zur Herstellung der Dispersion kann die Schritte enthalten:
A Vermischen der Komponenten A bis C sowie gegebenenfalls D, E und weitere Komponenten und
B Dispergieren der Mischung.

Die Dispersionshersteltung kann durch intensives Mischen und Dispergieren mit in der Fachwelt bekannten Aggregaten durchgeführt werden. Dies beinhaltet Vermischen der Komponenten in einem Dissolver oder einem vergleichbar intensiv dispergierenden Aggregat, die Dispergierung in einer Rührwerkskugelmühle oder einem Pulverfluidisator für große Mengen.

Als Substrat eignen sich elektrisch nicht leitfähige Werkstoffe wie Polymere. Geeignete Polymere sind Epoxyharze, zum Beispiel bifunktionelle oder polyfunktionelle, aramidverstärkte oder glasfaserverstärkte oder papierverstärkte Epoxyharze (zum Beispiel FR4), glasfaserverstärkte Kunststoffe, Liquid Cristal-Polymere (LCP), Polyphenylensulfide (PPS), Polyoxymethylene (POM), Polyaryletherketone (PAEK), Polyetheretherketone (PEEK), Polyamide (PA), Polycarbonate (PC), Polybutylenterephthalate (PBT), Polyethylenterephthalate (PET), Polyimide (PI), Polyimidharze, Cyanatester, Bismaleimid-Triazin-Harze, Nylon, Vinylesterharze, Polyester, Polyesterharze, Polyamide, Polyaniline, Phenolharze, Polypyrrole, Polynaphthalenterephthalate, Polymethylmethacrylat, phosphormodifizietrte Epoxidharze, Polyethylendioxythiophene, Phenolharz beschichtetes Aramidpapier, Polytetrafluorethylen (PTFE), Melaminharze, Silikonharze, Fluorharze, Dielektrika, APPE, Polyetherimide (PEI), Polyphenylenoxide (PPO), Polypropylene (PP), Polyethylene (PE), Polysulfone (PSU), Polyethersulfone (PES), Polyarylamide (PAA), Polyvinylchloride (PVC), Polystyrole (PS), Acrylnitrilbutadienstyrole (ABS), Acrylnitrilstyrolacrylate (ASA), Styrolacrylnitrile (SAN) sowie Mischungen (Blends) zweier oder mehrerer der oben genannten Polymere, welche in verschiedensten Formen vorliegen können. Die Substrate können für den Fachmann bekannte Additive wie beispielsweise Flammschutzmittel aufweisen.

Prinzipiell können auch alle unter der Komponente A aufgeführten Polymere eingesetzt werden. Geeignet sind auch andere ebenso in der Leiterplattenindustrie übliche Substrate.

Weiterhin sind geeignete Substrate Verburidwerkstoffe, schaumartige Polymere, Styropor^{®}, Styrodur^{®}, keramische Oberflächen, Textilien, Pappe, Karton, Papier, polymerbeschichtetes Papier, Holz, mineralische Materialien, Glas, Pflanzengewebe sowie Tiergewebe.

Im Rahmen der vorliegenden Erfindung wird unter dem Begriff "nicht elektrisch leitfähig" vorzugsweise verstanden, dass der spezifische Widerstand mehr als 10⁹ Ohm x cm beträgt.

Das Aufbringen der Dispersion kann nach für den Fachmann bekannten Methoden erfolgen. Das Aufbringen auf die Substratoberfläche kann ein- oder mehrseitig erfolgen und sich auf eine, zwei oder drei Dimensionen erstrecken. Generell kann das Substrat eine beliebige dem Verwendungszweck angepasste Geometrie aufweisen.

Ebenso erfolgt das Trocknen der aufgebrachten Schicht nach üblichen Methoden. Alternativ kann das Bindemittel auch auf chemischem öder physikalischem Wege, beispielsweise durch UV-Strahlung oder Temperatur ausgehärtet werden.

Das Trocknen und/oder Aushärten kann vollständig oder teilweise erfolgen.

Die nach Aufbringen der Dispersion und Trocknen und/oder Härten erhaltene Schicht ermöglicht eine anschließende stromlose und/oder galvanische Abscheidung eines Metalls auf der getrockneten Dispersionsschicht.

Die Dispersion kann in Schritt a) strukturiert oder flächig aufgebracht werden. Es ist bevorzugt, wenn die Schritte des Aufbringens (Schritt a), des Trocknens und/oder Härtens (Schritt b) und gegebenenfalls die Abscheidung eines weiteren Metalls (Schritt c) in kontinuierlicher Fahrweise durchgeführt werden. Dies ist durch die einfache Durchführung der Schritte a), b) und gegebenenfalls c) möglich. Es ist jedoch selbstverständlich ein batchweises oder semi-kontinuierliches Verfahren möglich.

Die Beschichtung kann mit den üblichen und allgemein bekannten Beschichtungsverfahren (Gießen, Streichen, Rakeln, Bepinseln, Drucken (Tiefdruck, Siebdruck, Flexodruck, Tampondruck, InkJet, Offset usw.), Sprühen, Tauchen, Bepudem, Wirbelschicht etc.) erfolgen. Die Schichtdicke variiert vorzugsweise zwischen 0,01 und 100 µm, weiterhin bevorzugt zwischen 0,1 und 50 µm, insbesondere bevorzugt zwischen 1 und 25 µm. Die Schichten können sowohl vollflächig als auch strukturiert aufgebracht werden.

Die in Schritt c) durchgeführte stromlose und/oder galvanische Abscheidung eines Metalls kann nach dem für den Fachmann bekannten und in der Literatur beschriebenen Verfahren durchgeführt werden. Es kann eine oder es können mehrere Metallschichten stromlos und/oder galvanisch, d.h. unter Anlegen äußerer Spannung und Stromfluss, aufgebracht werden. Prinzipiell kommen alle Metalle, die edler oder gleich edel wie das unedelste Metall der Dispersion für die stromlose und/oder galvanische Abscheidung in Frage. Bevorzugt werden Kupfer-, Chrom-, Silber-, Gold und/oder Nickelschichten galvanisch abgeschieden. Auch die galvanische Abscheidung von Schichten aus Aluminium ist bevorzugt. Die Dicken der einen oder mehreren abgeschiedenen Schichten in Schritt c) liegen im üblichen, dem Fachmann bekannten Bereich und sind nicht erfindungswesentlich.

Ein weiterer Gegenstand der vorliegenden Erfindung ist eine Substratoberfläche mit zumindest teilweise aufweisender elektrisch leitfähiger Metallschicht, die nach dem oben beschriebenen erfindungsgemäßen Verfahren zur Herstellung einer Metallschicht erhältlich ist.

Eine solche Substratoberfläche kann zur Leitung von elektrischem Strom oder Wärme, zur Abschirmung von elektromagnetischer Strahlung sowie zur Magnetisierung verwendet werden.

Ein weiterer Gegenstand der vorliegenden Erfindung liegt in der Verwendung einer wie oben angegebenen Dispersion zum Aufbringen einer Metallschicht.

Die erfindungsgemäße Substratoberfläche kann insbesondere für verschiedene nachfolgend aufgeführte Anwendungen zum Einsatz kommen.

So ist zum Beispiel die Herstellung von Leiterbahnstrukturen, zum Beispiel zur Herstellung von Antennen, wie RFID-Antennen, Transponder-Antennen, Leiterplatten (Multilayer-Innen-und Außenlagen, Micro-via, chip-on-board, flexible und starre Leiterplatten, Papier und Komposite usw.), Flachkabel, Sitzheizungen, kontaktlose Chipkarten, Kondensatoren, Widerstände, Konnektoren, Folienleiter, elektrische Sicherungen möglich.

Weiterhin ist die Herstellung von Antennen mit Kontakten für organische Elektronikbauteile sowie von Beschichtungen auf Oberflächen bestehend aus elektrisch nicht leitfähigem Material zur elektromagnetischen Abschirmung (shielding) möglich.

Weiterhin ist die Herstellung einer metallischen Innenbeschichtung zur Realisierung von Hohlleitern für Hochfrequenzsignale mit einer mechanisch tragenden Struktur aus elektrisch nicht leitfähigem Material möglich. Ebenso kann die Substratoberfläche Teil von Folienkondensatoren sein.

Eine Verwendung ist weiterhin im Bereich der Flowfields von Bipolarplatten zur Anwendung in Brennstoflzellen möglich.

Weiterhin ist die Herstellung einer vollflächigen oder strukturierten elektrisch leitfähigen Schicht zur anschließenden Dekormetallisierung von Formteilen aus dem oben erwähnten elektrisch nicht leitfähigen Substrat möglich. Ebenso ist die Herstellung von Metallschäumen (zum Beispiel für Crashabsorber) denkbar.

Die Anwendungsbreite des erfindungsgemäßen Verfahrens zur Herstellung einer Metallschicht mit Hilfe der erfindungsgemäßen Dispersion sowie der erfindungsgemäßen Substratoberfläche ermöglicht eine kostengünstige Herstellung von metallisierten, selbst nicht leitenden Substraten, insbesondere für die Verwendung als Schalter, Sensoren und MIDs (Molded interconnect devices), Absorber für elektromagnetische Strahlung oder Gasbarrieren oder Dekorteile, insbesondere Dekorteile für Kraftfahrzeug-, Sanitär-, Spielzeug-, Haushalts- und Bürobereich und Verpackungen sowie Folien. Auch im Bereich Sicherheitsdruck für Geldscheine, Kreditkarten, Ausweispapiere usw. kann die Erfindung Anwendung finden. Textilien können mit Hilfe des erfindungsgemäßen Verfahrens elektrisch und magnetisch funktionalisiert werden (Antennen, Sender, RFID- und Transponderantennen, Sensoren, Heizelemente, Antistatik (auch für Kunststoffe), Abschirmungen usw.).

Beispiele für solche Anwendungen sind Gehäuse, beispielsweise Computergehäuse, Gehäuse für Bildschirme, Handy, Audio, Video, DVD, Kamera, Gehäuse für elektronische Bauteile, militärische und nicht-militärische Abschirmeinrichtungen, Dusch- und Waschtischarmaturen, Duschköpfe, Duschstangen und -halter, metallisierte Türdrücker und Türknöpfe, Toilettenpapierrollenhalter, Badewannengriffe, metallisierte Zierstreifen auf Möbeln und Spiegeln, Rahmen für Duschabtrennungen, Verpackungsmaterialien.

Weiterhin seien genannt: metallisierte Kunststoffoberflächen im Automobilbereich wie zum Beispiel Zierstreifen, Außenspiegel, Kühlergrills, Frontend-Metallisierung, Windleitflächen, Karosserie-Außen- und Innenteile, Türschweller, Trittblech-Ersatz, Radzierblenden.

Weiterhin sind solche Teile aus nicht leitfähigem Material herstellbar, die bislang teilweise oder ganz aus Metallen hergestellt wurden. Beispielhaft seien hier genannt Fallrohre, Dachrinnen, Türen sowie Fensterrahmen.

Weiterhin ist die Herstellung von Kontaktstellen bzw. Kontakt-Pads oder Verdrahtungen auf einem integrierten elektrischen Bauelement möglich.

Die oben angegebene Dispersion kann ebenfalls für die Metallisierung von Löchern, Vias, Sacklöchern usw. bei Leiterplatten mit dem Ziel einer Durchkontaktierung der oberen und unteren Leiterplattenseite verwendet werden. Dies gilt auch, wenn andere Substrate verwendet werden.

Weiterhin finden die erfindungsgemäß hergestellten metallisierten Gegenstände - sofern sie magnetisierbare Metalle umfassen - Anwendung in Bereichen magnetisierbarer Funktionsteile wie Magnettafeln, Magnetspiele, magnetische Flächen bei zum Beispiel Kühlschranktüren. Außerdem finden sie Anwendung in Bereichen, in denen eine gute thermische Leitfähigkeit vorteilhaft ist, beispielsweise in Folien für Sitzheizungen, Fußbodenheizungen sowie Isolierungsmaterialien.

Bevorzugte Verwendungen der erfindungsgemäß metallisierten Substratoberfläche sind solche, bei denen das so hergestellte Substrat als Leiterplatte, RFID-Antenne, Transponderantenne, Sitzheizung, Flachkabel oder kontaktlose Chipkarten dient.

### Beispiele

### Beispiel 1

8,4 g eines Ethylenvinylacetat-Copolymers werden in 126 g n-Butylacetat gelöst. In dieser Lösung werden 378 g kugelförmiges Eisenpulver und 42,0 g plättchenförmiges Kupferpulver mit Hilfe eines Dissolverrührers eindispergiert. Die erhaltene Dispersion wird in einer Dicke von 4 µm auf eine geprimerte PET-Folie aufgetragen. Nach der Trocknung wird in einem sauren Kupfersulfatbad eine Kupferschicht von 9 µm Dicke aufgebracht.

### Beispiel 2

8,4 g eines Ethylenvinylacetat-Copolymers werden in 96,6 g n-Butylacetat gelöst. In dieser Lösung werden 378 g kugelförmiges Eisenpulver und 42,0 g plättchenförmiges Kupferpulver mit Hilfe eines Dissolverrührers eindispergiert. Die erhaltene Dispersion wird in einer Dicke von 4 µm auf eine geprimerte PET-Folie aufgetragen. Nach der Trocknung wird in einem sauren Kupfersulfatbad eine Kupferschicht von 9 µm Dicke aufgebracht.

### Beispiel 3

Beispiel 1 wird wiederholt unter Verwendung von plättchenförmigem Eisenpulver anstelle von plättchenförmigem Kupferpulver.

### Beispiel 4

Beispiel 1 wird wiederholt unter Verwendung von Carbonyleisenpulver anstelle von konventionellem Eisenpulver.

In allen Fällen zeigt sich, dass bei Weglassen einer Metallkomponente sich jeweils eine ungleichmäßigere Kupferschicht ergibt, die darüber hinaus auch eine schlechtere Haftung aufweist.

## Patentansprüche

1. Verfahren zur Herstellung einer Metallschicht auf zumindest einem Teil der Oberfläche eines nicht leitfähigen Substrats die Schritte enthaltend
a) Aufbringen einer Dispersion zum Aufbringen einer Metallschicht auf einem elektrisch nicht leitfähigen Substrat enthaltend
A 0,01 bis 30 Gew.-% bezogen auf das Gesamtgewicht der Dispersion einer organischen Bindemittelkomponente;
B 30 bis 89,99 Gew.-% bezogen auf das Gesamtgewicht der Dispersion einer Metallkomponente mindestens enthaltend
B1 0,01 bis 99,99 Gew.-% bezogen auf das Gesamtgewicht der Metallkomponente B eines ersten Metalls mit einer ersten Metallteilchenform und
B2 99,99 bis 0,01 Gew.-% bezogen auf das Gesamtgewicht der Metallkomponente B eines zweiten Metalls mit einer zweiten Metallteilchenform;
C 10 bis 69,99 Gew.-% bezogen auf das Gesamtgewicht der Dispersion einer Lösemittelkomponente;
wobei mindestens eine der folgenden Bedingungen erfüllt ist:
(1) Das erste und zweite Metall sind verschieden;
(2) Die erste und zweite Teilchenform sind verschieden
auf dem Substrat;
b) Trocknen und/oder Aushärten der aufgebrachten Schicht auf dem Substrat; und
c) gegebenenfalls stromlose und/oder galvanische Abscheidung eines Metalls auf der getrockneten und/oder ausgehärteten Dispersionsschicht.

2. Verfahren nach Anspruch 1, **dadurch gekennzeichnet, dass** die Dispersion weiterhin mindestens einer der Komponenten
D mit 0,01 bis 50 Gew.-% bezogen auf das Gesamtgewicht der Dispersion einer Dispergiermittelkomponente; sowie
E mit 0,01 bis 50 Gew.-% bezogen auf das Gesamtgewicht der Dispersion einer Füllstoffkomponente enthält.

3. Verfahren nach Anspruch 1 oder 2, **dadurch gekennzeichnet, dass** die Bindemittelkomponente A aus einem Polymer oder Polymergemisch besteht.

4. Verfahren nach einem der Ansprüche 1 bis 3, **dadurch gekennzeichnet, dass** das erste und zweite Metall gegebenenfalls gecoatet und unabhängig voneinander ausgewählt sind aus der Gruppe bestehend aus Zink, Nickel, Kupfer, Zinn, Kobalt, Mangan, Eisen, Magnesium, Blei, Chrom, Wismut, Silber, Gold, Aluminium, Titan, Palladium, Platin, Tantal und Legierungen hiervon.

5. Verfahren nach einem der Ansprüche 1 bis 4, **dadurch gekennzeichnet, dass** die erste und zweite Teilchenform unabhängig voneinander ausgewählt sind aus der Gruppe bestehend aus nadelförmig, zylindrisch, plattenförmig und kugelförmig.

6. Verfahren nach einem der Ansprüche 1 bis 5, **dadurch gekennzeichnet, dass** das erste und zweite Metall verschieden sind.

7. Verfahren nach Anspruch 6, **dadurch gekennzeichnet, dass** das erste Metall und das zweite Metall ausgewählt sind aus der Gruppe bestehend aus Eisen, Kupfer, Zink und Aluminium.

8. Verfahren nach einem der Ansprüche 1 bis 7, **dadurch gekennzeichnet, dass** die erste und zweite Teilchenform unterschiedlich sind.

9. Verfahren nach Anspruch 8, **dadurch gekennzeichnet, dass** die erste Teilchenform kugelförmig und die zweite Teilchenform plattenförmig oder nadelförmig ist.

10. Verfahren nach einem der Ansprüche 1 bis 9, **dadurch gekennzeichnet, dass** der mittlere Teilchendurchmesser des ersten und zweiten Metalls im Bereich von 0,01 bis 100 µm liegt.

11. Verfahren nach einem der Ansprüche 1 bis 10, **dadurch gekennzeichnet, dass** in Schritt a) die Dispersion strukturiert oder flächig aufgebracht wird.

12. Verfahren nach einem der Ansprüche 1 bis 11, **dadurch gekennzeichnet, dass** zumindest einer der Schritte a), b) und gegebenenfalls c) in zumindest teilweise kontinuierlicher Fahrweise durchgeführt werden.

13. Substratoberfläche mit zumindest teilweise aufweisender elektrisch leitfähiger Metallschicht erhältlich aus dem Verfahren nach einem der Ansprüche 1 bis 12.

14. Verwendung einer Substratoberfläche nach Anspruch 13 zur Leitung von elektrischem Strom, Wärme, als Dekormetalloberfläche, zur Abschirmung von elektromagnetischer Strahlung sowie zur Magnetisierung.

15. Verwendung nach Anspruch 14 als Leiterplatte, RFID-Antenne, Transponderantenne, Sitzheizung, Flachkabel oder kontaktlose Chipkarte.

16. Verwendung einer Suspension wie in einem der Ansprüche 1 bis 10 angegeben zum Aufbringen einer Metallschicht.

## Claims

1. A process for production of a metal layer on at least one portion of the surface of a substrate that is not electrically conductive, the steps comprising
a) application of a dispersion for application of a metal layer on a substrate that is not electrically conductive, comprising
A from 0.01 to 30% by weight, based on the total weight of the dispersion, of an organic binder component;
B from 30 to 89.99% by weight, based on the total weight of the dispersion, of a metal component at least comprising
B1 from 0.01 to 99.99% by weight, based on the total weight of the metal component B, of a first metal with a first metal particle shape, and
B2 from 99.99 to 0.01 % by weight, based on the total weight of the metal component B, of a second metal with a second metal particle shape;
C from 10 to 69.99% by weight, based on the total weight of the dispersion, of a solvent component;
where at least one of the following conditions has been met:
(1) the first and second metal are different;
(2) the first and second particle shape are different
on the substrate;
b) drying and/or hardening of the applied layer on the substrate; and
c) if appropriate, deposition of a metal by a currentless and/or electroplating method on the dried and/or hardened dispersion layer.

2. The process according to claim 1, wherein the dispersion moreover comprises at least one of the following components
D from 0.01 to 50% by weight, based on the total weight of the dispersion, of a dispersing agent component; and
E from 0.01 to 50% by weight, based on the total weight of the dispersion, of a filler component.

3. The process according to claim 1 or 2, wherein the binder component A is composed of a polymer or polymer mixture.

4. The process according to any of claims 1 to 3, wherein, if appropriate, the first and second metal have been coated, having been selected independently of one another from the group consisting of zinc, nickel, copper, tin, cobalt, manganese, iron, magnesium, lead, chromium, bismuth, silver, gold, aluminum, titanium, palladium, platinum, tantalum, and alloys thereof.

5. The process according to any of claims 1 to 4, wherein the first and second particle shape have been selected independently of one another from the group consisting of acicular, cylindrical, lamellar, and spherical.

6. The process according to any of claims 1 to 5, wherein the first and second metal are different.

7. The process according to claim 6, wherein the first metal and the second metal have been selected from the group consisting of iron, copper, zinc, and aluminum.

8. The process according to any of claims 1 to 7, wherein the first and second particle shape are different.

9. The process according to claim 8, wherein the first particle shape is spherical and the second particle shape is lamellar or acicular.

10. The process according to any of claims 1 to 9, wherein the average particle diameter of the first and second metal is in the range from 0.01 to 100 µm.

11. The process according to any of claims 1 to 10, wherein, in layer a), the dispersion is applied in structured or full-surface form.

12. The process according to any of claims 1 to 11, wherein at least one of the steps a), b), and, if appropriate, c) is carried out in an at least to some extent continuous procedure.

13. A substrate surface with at least partially present electrically conductive metal layer obtainable from the process according to any of claims 1 to 12.

14. The use of a substrate surface according to claim 13 for conduct of electrical current, or of heat, or as a decorative metal surface, or for screening of electromagnetic radiation, or for magnetization.

15. The use according to claim 14 as a printed circuit board, RFID antenna, transponder antenna, seat-heating system, ribbon cable, or contactless chip card.

16. The use of a suspension as specified in any of claims 1 to 10 for application of a metal layer.

## Revendications

1. Procédé de fabrication d'une couche métallique sur au moins une partie de la surface d'un substrat non conducteur de l'électricité, contenant les étapes
a) application d'une dispersion pour l'application d'une couche métallique sur un substrat non conducteur de l'électricité, contenant
A 0,01 à 30 % en poids, par rapport au poids total de la dispersion, d'un composant de liant organique ;
B 30 à 89,99 % en poids, par rapport au poids total de la dispersion, d'un composant métallique contenant au moins
B1 0,01 à 99,99 % en poids, par rapport au poids total du composant métallique B, d'un premier métal ayant une première forme de particule métallique et
B2 99,99 à 0,01 % en poids, par rapport au poids total du composant métallique B, d'un second métal ayant une seconde forme de particule métallique ;
C 10 à 69,99 % en poids, par rapport au poids total de la dispersion, d'un composant de solvant ;
au moins une des conditions suivantes étant remplie :
(1) le premier et le second métal sont différents ;
(2) la première et la seconde forme de particule sont différentes
sur le substrat ;
b) séchage et/ou durcissement de la couche appliquée sur le substrat ; et
c) éventuellement dépôt sans courant et/ou galvanique d'un métal sur la couche de dispersion séchée et/ou durcie.

2. Procédé selon la revendication 1, **caractérisé en ce que** la dispersion contient également au moins un des composants
D 0,01 à 50 % en poids, par rapport au poids total de la dispersion, d'un composant d'agent de dispersion ; et
E 0,01 à 50 % en poids, par rapport au poids total de la dispersion, d'un composant de charge.

3. Procédé selon la revendication 1 ou 2, **caractérisé en ce que** le composant de liant A est constitué d'un polymère ou d'un mélange de polymères.

4. Procédé selon l'une quelconque des revendications 1 à 3, **caractérisé en ce que** le premier et le second métal sont éventuellement enduits et choisis indépendamment l'un de l'autre dans le groupe constitué du zinc, nickel, cuivre, étain, cobalt, manganèse, fer, magnésium, plomb, chrome, bismuth, argent, or, aluminium, titane, palladium, platine, tantale et leurs alliages.

5. Procédé selon l'une quelconque des revendications 1 à 4, **caractérisé en ce que** la première et la seconde forme de particule sont choisies indépendamment l'une de l'autre dans le groupe constitué d'aciculaire, cylindrique, plate et sphérique.

6. Procédé selon l'une quelconque des revendications 1 à 5, **caractérisé en ce que** le premier et le second métal sont différents.

7. Procédé selon la revendication 6, **caractérisé en ce que** le premier métal et le second métal sont choisis dans le groupe constitué du fer, cuivre, zinc et aluminium.

8. Procédé selon l'une quelconque des revendications 1 à 7, **caractérisé en ce que** la première et la seconde forme de particule sont différentes.

9. Procédé selon la revendication 8, **caractérisé en ce que** la première forme de particule est sphérique et la seconde forme de particule est plate ou aciculaire.

10. Procédé selon l'une quelconque des revendications 1 à 9, **caractérisé en ce que** le diamètre de particule moyen du premier et du second métal se situe dans la plage allant de 0,01 à 100 µm.

11. Procédé selon l'une quelconque des revendications 1 à 10, **caractérisé en ce qu'**à l'étape a), la dispersion est appliquée de manière structurée ou plane.

12. Procédé selon l'une quelconque des revendications 1 à 11, **caractérisé en ce qu'**au moins une des étapes a), b) et éventuellement c) est réalisée de manière au moins partiellement continue.

13. Surface de substrat présentant au moins partiellement une couche métallique conductrice de l'électricité pouvant être obtenue par le procédé selon l'une quelconque des revendications 1 à 12.

14. Utilisation d'une surface de substrat selon la revendication 13 pour la conduction d'un courant électrique, de chaleur, en tant que surface métallique décorative, pour le blindage contre un rayonnement électromagnétique et pour la magnétisation.

15. Utilisation selon la revendication 14, en tant que plaque conductrice, antenne RFID, antenne de transpondeur, chauffage de siège, câble plat ou carte à puce sans contact.

16. Utilisation d'une suspension selon l'une quelconque des revendications 1 à 10 pour l'application d'une couche métallique.
